# EUROPEAN PATENT APPLICATION

(11) **EP 3 855 493 A1**
(43) Date of publication of application: **28.07.2021**
(21) Application number: 20305045.5
(22) Date of filing: 21.01.2020
(51) Int. Cl.: H01L 27/02, H01L 23/00, G03F 7/20, G03F 1/00

(54) **METHODS OF MANUFACTURING IC DEVICES ON WAFERS, ASSOCIATED WAFERS AND RETICLES**

(71) Applicant: Murata Manufacturing Co., Ltd., Nagaokakyo-shi, Kyoto 617-8555 (JP)
(72) Inventor: JACQUELINE, Sébastien, 14000 Caen (FR); AUBRY, Yves, 14000 Caen (FR); VOIRON, Frédéric, 38530 Barraux (FR)
(74) Representative: Cabinet Beau de Loménie

(57) **Abstract**

In the case of reproducing across a wafer (20) surface an integrated circuit (10) having non-uniformity in the distribution of 3D structures therein, wafer warpage can be reduced by providing in the same wafer surface compensation elements (30) that likewise extend in the thickness direction of the wafer and are positioned to render the distribution of 3D structures over the whole wafer layout more uniform. The compensation elements (30) may comprise rotated instances of the basic IC (10). The compensation elements (30a) may comprise 3D structures that extend in a direction transverse to a first direction in which the 3D structures of the basic ICs align on the wafer.

## Description

### Field of the Invention

The present invention relates to the field of semiconductor manufacture and, in particular, to methods of manufacturing integrated circuit (IC) devices on wafers, to wafers, and to reticles, for reduction of warping or stress in wafers.

### Technical Background

In semiconductor manufacture it is commonplace to reproduce an integrated circuit (die) multiple times over the surface of a wafer and then to separate the individual ICs by cutting the wafer along dicing lanes. During the process of reproducing the IC multiple times over the wafer surface, light is shone through a reticle to define patterning for a layer in or on the wafer. The reticle usually defines patterning for one circuit, or for a small number of instances of the circuit, so a stepper translates the position of the reticle relative to the wafer by small steps in the x and/or y directions in-between successive illumination steps, until the full useful surface of the wafer has been exposed. Spaces are left in-between the various instances of the circuit on the wafer, so that singulation of the dies (scribing or dicing of the wafer to separate the individual ICs) does not damage active parts of the circuitry.

During semiconductor manufacture, stresses can arise in the semiconductor wafer due to a number of causes, and the stresses can lead to warping of the wafer. For example, the different materials present in the wafer may have different coefficients of thermal expansion and this can lead to creation of stress as the temperature changes. Whatever the origin of the stress/warping, if it becomes sufficiently extreme it may become difficult or impossible to complete the manufacturing process, for example, because the wafer becomes too fragile to be handled, without breaking, using conventional handling apparatus. Various proposals have been made to tackle the problem of stress/warping of semiconductor wafers due, for example, to thermal effects, such as US 8080870 and US 2014/374914.

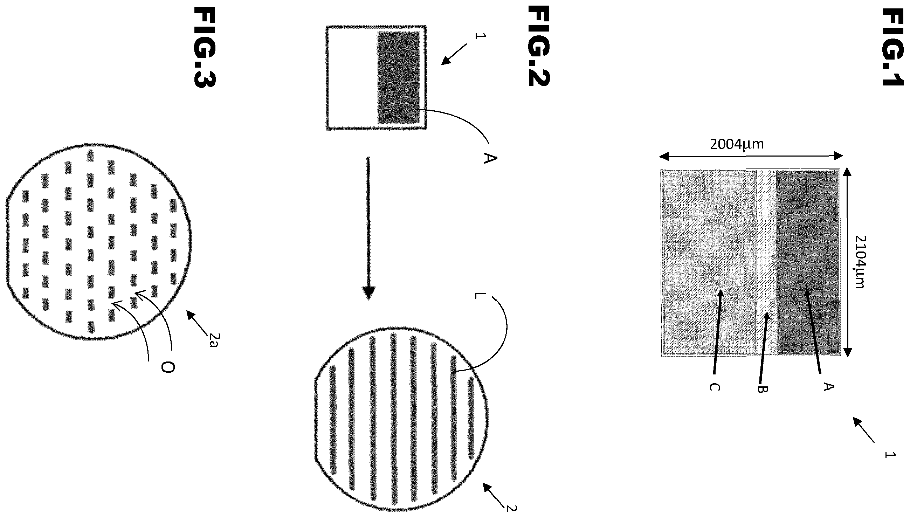

The present inventors have realized that there is a specific cause of stress/warping in semiconductor wafers that has not been recognized previously. In particular, significant stresses may arise in a case where the basic circuit being reproduced across the wafer is asymmetrical in terms of the distribution therein of structures that extend in the thickness direction of the wafer. For example, in a case where the circuit to be reproduced contains a large number of three-dimensional structures - for example 3D capacitors, through vias, etc. - the circuit may require a large number of deep holes, or pillars, to be formed in the wafer. The situation may arise that the distribution of the capacitors within the circuit is uneven, e.g. a region on one side of the circuit may have a large number of deep holes or trenches whereas the remainder of the circuit may have no or few holes/trenches. When a circuit of such a type is reproduced across the wafer, the regions containing holes/trenches tend to align with one another and the regions lacking holes/trenches (or having few holes/trenches) also tend to align with one another, resulting in macroscopic features extending across the wafer and causing stresses in a preferential direction. This phenomenon is illustrated in Figs.1 and 2.

Fig.1 is a plan view of an integrated passive device 1 which has a first region, A, in which there is a high density of holes in the thickness direction of the wafer. In this example, the holes contain dielectric and electrode layers forming 3D capacitors. The regions A are represented as dark rectangles in Fig.1 and in Figs.2-5 discussed below. The remainder of the circuit (regions B and C) has no holes but in region C there is surface metallization, e.g. a metal electrode-pad having width of 2mm and length of 1mm is provided on the surface of the circuit. It can be understood that in this device 10 there is a highly uneven distribution of structures that extend in the thickness direction (into the page), with many thickness-direction structures present in the region A and none in the regions B and C.

Fig.2 is a diagram illustrating the result of reproducing the circuit 1 of Fig.1 using a reticle and stepper in a conventional manner. It can be seen from Fig.2 that when the integrated device of Fig.1 is reproduced across a wafer 2 in a conventional manner, the regions A having a high density of thickness-direction structures line up with one another, and the regions B, C having a low density of thickness-directions structures also line up with one another. This produces elongated linear regions L having a high density of thickness-direction structures, these linear regions L extend across the wafer in a preferential direction (the side-to-side direction in Fig.2) and this produces macroscopic stress effects leading to warping of the wafer.

Indeed, when the circuit of Fig.1 is reproduced across a silicon wafer of diameter 15 cm (6 inch wafer), it has been found not only that the wafer warps but also that the curvature across the width of the wafer (i.e. in the side-to-side direction of Fig.2) is significantly different from the curvature across the length of the wafer (i.e. in the top-to-bottom direction of Fig.2) both in magnitude and in direction. When the curvature is expressed as a diameter of a circle containing the curved surface, the diameter is 11m and -112m in the two directions, respectively. This high degree of warping, and the difference between the curvatures in the two directions, can make processing of the wafer using conventional manufacturing apparatus difficult, or even impossible.

Fig.3 illustrates one approach that could be taken in an attempt to reduce the macroscopic stresses caused when the circuit reproduced across a wafer 2a has a high degree of non-uniformity in the distribution of thickness-direction structures, notably a high concentration of 3D structures at one side of the circuit. According to the illustrated approach, a certain number of repetitions of the circuit are omitted at locations, O, which interrupt the linear structures that would otherwise form across the wafer. However, this approach has the disadvantage of reducing the manufacturing yield because, typically, the number of circuits that could be produced on a given wafer would be approximately halved.

The present invention has been made in the light of the above problems.

### Summary of the Invention

The present invention provides a method of manufacturing integrated circuit devices on a wafer, comprising:
forming in a first surface of the wafer a first set of repetitions of an integrated circuit, said integrated circuit comprising structures extending in the thickness-direction of the wafer and said thickness-direction structures being laid out unevenly across the integrated circuit, wherein the positions of the integrated circuits of the first set on the wafer cause a non-uniform distribution of thickness-direction structures over the surface of the wafer, and
forming, in said first surface of the wafer, compensation elements extending in the thickness direction of the wafer and increasing the uniformity in distribution of thickness-direction structures across the wafer compared to said non-uniform distribution.

The manufacturing method according to the invention improves the uniformity of the distribution, across the wafer, of three-dimensional structures (i.e. structures that extend in the thickness direction of the wafer) in the case where the wafer is being used to manufacture multiple instances of an integrated circuit device that has 3D structures unevenly distributed within it. The improved uniformity in the distribution of the 3D structures tends to even out stresses in different directions across the wafer, leading to reduced difference in the curvature of the wafer in different directions, and may reduce warping overall.

The compensation elements may be formed in different ways. According to a first aspect of the invention, the compensation elements are formed by creating in the first surface of the substrate a second set of repetitions of the basic integrated circuit, having a rotated orientation on the wafer relative to the orientation of the integrated circuits of the first set. This amounts to forming the ICs on the wafer in more than one orientation. This approach is simple to implement because the different orientations of the IC can be produced on the wafer using a reticle that has patterns corresponding to the different orientations of the IC, or the relative orientation of the wafer and a standard reticle (i.e. a reticle including one or more repetitions of a layer of the IC in a single orientation) can be changed, in rotation, between different exposures of the wafer.

According to a second aspect of the invention, in a case where the integrated circuits of the first set are formed on the wafer at positions causing alignment of thickness-direction structures in rows extending in a first direction across the wafer, the compensation elements may be formed, in the first surface of the substrate, to extend in a direction transverse to the first direction.

Compensation elements of the later type, extending in a direction transverse to the first direction, may be formed in dicing lanes of the wafer. In such a case the compensation elements do not take up useful real estate on the wafer surface, and thus they leave space for formation of a large number of ICs on the wafer.

The formation of compensation elements according to the invention can be achieved in an efficient manner, avoiding increase in the overall number of process steps, by using common process steps to form both the 3D structures in the integrated circuits of the first set and the compensation elements extending in the thickness-direction of the wafer. Thus, for example, both sets of structures can be patterned and etched in common patterning and etching processes. Accordingly, wafer warping can be reduced without significant increase in complexity of the manufacturing process.

In a similar manner, in some embodiments of the invention common process steps can be used to deposit material in the thickness-direction structures in the first set of integrated circuits and to deposit the same material in the compensation elements that extend in the thickness direction of the wafer. So, for example, if the 3D structures in the IC are 3D trench capacitors having dielectric and electrode layers extending conformally over wells in the wafer, the compensation elements can likewise be wells and the same dielectric and electrode layers can be deposited in the compensation elements in the same process step which deposits those layers in the 3D capacitors. Once again, this enables wafer warping to be reduced without significant increase in complexity of the manufacturing process. Moreover, by putting the same materials into the compensation elements as are put into the 3D structures of the IC, stress effects related to the nature of the filling materials will tend to be compensated more accurately.

The present invention further provides a wafer comprising:
in a first surface of the wafer, a first set of repetitions of an integrated circuit, said integrated circuit comprising structures extending in the thickness-direction of the wafer and said thickness-direction structures being laid out unevenly across the integrated circuit, wherein the positions of the integrated circuits of the first set on the wafer cause a non-uniform distribution of thickness-direction structures over the surface of the wafer, and
compensation elements extending in the thickness direction of the wafer and increasing the uniformity in distribution of thickness-directions structures across the wafer compared to said non-uniform distribution.

Wafers according to the present invention may tend to have less warping overall, and more even curvature in different directions, than comparable wafers which bear repetitions of an IC having a non-uniform distribution of 3D structures but lack the compensation elements.

In certain wafers embodying the invention, the compensation elements comprise a second set of repetitions of the integrated circuit, each disposed on the wafer in an orientation rotated relative to the orientation of the integrated circuits of the first set.

In certain wafers embodying the invention, where the integrated circuits of the first set comprise integrated circuits disposed on the wafer at positions causing alignment of thickness-direction structures in rows extending in a first direction across the wafer, the compensation elements on the wafer comprise structures extending in a direction transverse to the first direction. These compensation elements may comprise compensation elements disposed in dicing lanes of the wafer.

In certain wafers embodying the invention, one or more materials are present in the thickness-direction structures of the integrated circuits of the first set and the same one or more materials are present in the compensation elements extending in the thickness-direction of the wafer.

The present invention further provides a reticle to pattern a layer of a wafer in manufacture of an integrated circuit, the integrated circuit comprising structures extending in the thickness-direction of the wafer and said thickness-direction structures being laid out unevenly across the integrated circuit, the reticle comprising:
a set of one or more first patterns corresponding to a layer of the integrated circuit, and
a set of one or more second patterns corresponding to said layer of the integrated circuit, said second pattern being a rotated version of said first pattern to compensate for lack of uniformity in the distribution of thickness-direction structures in said integrated circuit.

The above-defined reticle makes it simple to fabricate a wafer comprising compensations structures that are a rotated version of the basic IC, because the usual exposure and stepper devices can be used with the reticle to create the basic ICs and the compensation structures at the same time.

### Brief Description of the Drawings

Further features and advantages of the present invention will become apparent from the following description of certain embodiments thereof, given by way of illustration only, not limitation, with reference to the accompanying drawings in which:
FIG. 1 is a plan view illustrating an example of an integrated circuit (IC) that has a markedly different concentration of 3D structures in different regions thereof;
FIG. 2 is a diagram illustrating how reproduction of the circuit of Fig.1 leads to macroscopic features on a wafer;
FIG. 3 is a diagram illustrating a possible approach for breaking up the macroscopic features illustrated in Fig.2;
FIG. 4 is a diagram illustrating an example implementation of a first embodiment of the invention using a first type of compensation element;
FIG. 5 is a diagram illustrating an example implementation of a second embodiment of the invention using a second type of compensation element;
FIGs. 6A and 6B are diagrams comparing wafer warpage when a first circuit is reproduced on a wafer, in which:

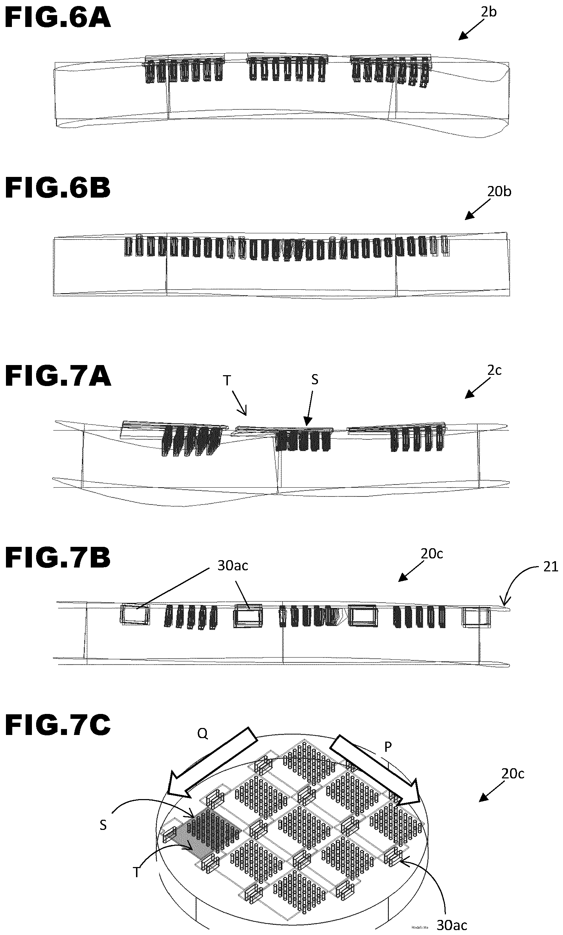

   FIG.6A illustrates the warping of the wafer according to a first comparative example, and
   FIG.6B illustrates the warping of the wafer according to an example implementation embodying the invention;
FIGs. 7A-7C are diagrams comparing wafer warpage when a second circuit is reproduced on a wafer, in which:
   FIG.7A illustrates the warping of the wafer according to a second comparative example,
   FIG.7B illustrates the warping of the wafer according to an example implementation embodying the invention (cross-sectional view), and
   FIG.7C is a perspective view corresponding to the example implementation of FIG.7B.

### Detailed Description of Example Embodiments

Principles of the present invention will become clear from the following description of certain example embodiments.

The example embodiments described below relate to fabrication of ICs containing so-called 3D capacitors, that is, capacitors formed using layers deposited over relief features in the wafer (e.g. dielectric and electrode layers formed over wells in the wafer, or dielectric and electrode layers formed over columns/pillars formed in the wafer). However, the skilled person will readily understand that the same principles may be applied in cases where the IC being reproduced across the wafer has structures, other than capacitors, extending in the thickness direction of the wafer.

The present inventors have realized that, in the case where an IC being reproduced across a wafer has non-uniformity in the distribution therein of 3D structures (structures extending in the thickness direction of the wafer), warping of the wafer can be mitigated by forming compensation elements that tend to improve the uniformity in the distribution of 3D structures over the wafer layout as a whole.

Factors which affect the degree of warpage of the wafer include the depth of the thickness-direction structures in the IC to be reproduced across the wafer, the shape of these structures, the number and distribution of such structures within the IC and across the wafer, and the nature of the materials used on the device. The principles of the present invention can be applied to reduce wafer warpage by compensation that can be adapted to these different factors. Thus, in certain embodiments o the invention, the distribution and number of 3D compensation structures formed in the wafer can be set in a manner adapted to the depth, shape, distribution etc. of 3D structures in the IC.

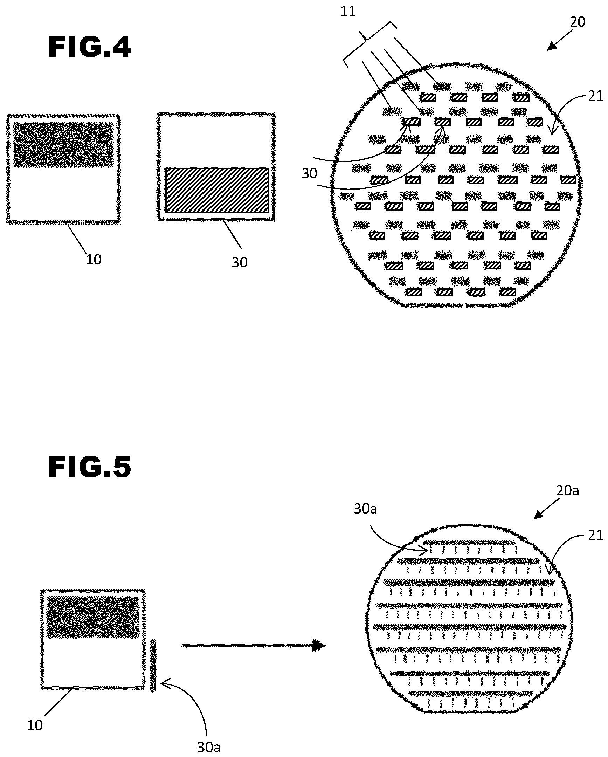

A first embodiment of the invention is illustrated by a diagram reproduced in Fig.4.

As illustrated in Fig.4, in the first embodiment of the invention a first set 11 of repetitions of an IC 10 are provided on a wafer 20, distributed across a first surface, 21, of the wafer. The IC 10 has 3D capacitors formed therein primarily in a region A of the circuit. The regions A are represented as solid, dark rectangles in Fig.4. In the example illustrated in Fig.4, when the first set 11 of repetitions of the IC 10 are reproduced on the wafer 20 they are aligned in a plurality of rows on the wafer surface and the regions A of the different ICs tend to line up, such that there is considerable lack of uniformity in the distribution across the wafer 20 of 3D structures in the first set 11 of repetitions of the IC.

According to the first embodiment of the invention, compensation elements 30 are formed across the surface of the wafer 20, in the same surface as the 3D structures of the IC 10, and these compensation elements 30 correspond to rotated copies of the IC. The regions A in the compensation elements 30 are represented as hashed rectangles in Fig.4. The compensation elements 30 are interposed between adjacent instances of the IC 10 along a row on the wafer surface. The interposing of the compensation elements 30 and their rotated orientation relative to the orientation of the first set 11 of repetitions of the IC 10 on the wafer surface 21, tends to render the distribution of 3D structures more uniform across the wafer surface as a whole.

In the example illustrated in Fig.4, the region A where the 3D structures are concentrated occupies approximately one half of the IC (when viewed in plan view). Accordingly, an 180° rotation of the orientation of the circuit reverses the positions of the regions of the IC that have a high concentration and a low concentration of 3D structures. Thus, in this example, the compensation elements 30 correspond to the IC 10 rotated through 180°. However, the invention is not limited to this example. Depending on the distribution of 3D structures in the IC 10 the compensation elements 30 may correspond to a rotation of the basic circuit through angles other than 180°. Furthermore, depending on the distribution of 3D structures in the IC 10 there may be different sets of compensation elements 30 oriented at different angles from each other and from the basic circuit 10.

In the embodiment illustrated in Fig.4, because the compensation elements 30 contain the same circuit components as the circuit 10, the materials and dimensions used therein are the same, with the consequence that the 3D structures in the compensation elements 30 have corresponding behavior (e.g. in term of thermal expansion) as the 3D structures in the first set of repetitions of the circuit 10. Accordingly, the stress-compensation achieved using the compensation elements 30 is well-matched to the properties of the IC circuit 10.

An example implementation of a second embodiment of the invention will now be described with reference to Fig.5.

According to the second embodiment of the invention, compensation elements 30a are formed across the surface of the wafer 20, in the same surface as the 3D structures of the IC 10, and these compensation elements 30a are configured to extend in a direction which is transverse to the direction in which regions A of the IC 10 tend to line up on the wafer. In the example illustrated in Fig.5, where the regions A of the IC 10 tend to line up in the widthwise direction of the wafer (as illustrated in the figure), the compensation structures 30a are configured to extend in the up-and-down direction in the figure.

It is convenient to associate one compensation structure to each IC reproduced on the wafer surface, but this is not essential. The number and dimensions of the compensation elements 30a can be adjusted as convenient for the manufacturing process. By providing on the wafer surface 21 compensation elements 30a extending in a direction transverse to the alignment direction of regions A of the ICs, the distribution of 3D structures across the wafer surface as a whole becomes more uniform.

In the example illustrated in Fig.5, each compensation element 30a is a single elongated slot whose long direction extends in a direction transverse to the alignment direction of the regions A on the wafer. In this specific example, the length direction of each compensation element 30a is approximately perpendicular to the alignment direction of the regions A. By extending in a direction that is perpendicular to the alignment direction of the regions A of the IC that have a high-density of 3D structures, the compensation elements 30a have a large effect in helping to render the distribution of 3D structures over the wafer more uniform. However, the invention is not limited to compensation elements 30a that extend in the perpendicular direction. A certain degree of compensation is still obtained even when the compensation element 30a extends in a direction which is not strictly the perpendicular to the alignment direction of the regions A and, in particular, useful amounts of compensation are likely to be obtained in a range of ±30° from the perpendicular direction.

Fig.5 illustrates a single slot 30a, but the present embodiment is not limited to that case. Two, or more than two slots 30a may be used as each compensation element.

Fig.5 illustrates a case where there is one compensation element 30a per IC in the first set 11 of repetitions of the IC, but the present embodiment is not limited to that case. Two, or more than two compensation elements 30a may be used per IC on the wafer, provided that space allows.

In order to avoid wasting space on the surface of the wafer, it can be advantageous to form the compensation elements 30a at locations that are within, or overlap with, the dicing lanes allocated for dicing or scribing the wafer.

The width and length of the compensation structures 30a are primarily chosen to compensate for the unbalanced distribution of 3D structures in the ICs 10. These dimensions of the compensation elements 30a will tend to be set larger for increasing length of the line L of aligned 3D structures in the ICs 10 (see Fig.2). In certain preferred embodiments of the invention, the width of each compensation element is set in the range of 5% to 30% of the width of the 3D pattern line L, i.e. typically the width is set in the range of 30µm - 180µm. However, the invention is not limited to use of a width within this range.

In the case where the compensation element 30a consists of a single slot, and this slot has a width in the range of approximately 30µm to approximately 180µm, it is likely that empty space will remain within the slot even if material is deposited therein during process steps that deposit material in the 3D structures of the ICs. One or more other filling steps may be provided to fill up the empty space (thus avoiding ingress of particles, residues and the like during subsequent manufacturing processes).

In the case where each compensation element 30a consists in a set of slots disposed side by side, it is the total width of the group of slots that is controlled, for example, to be in the range 30µm - 180µm mentioned above. For instance, each compensation element 30a may be a set of 15 slots, each 1µm wide with a spacing of 1µm between adjacent slots in the group, resulting in a total width of 29µm (approximately 30µm).

As noted above, it is also advantageous when the compensation structures 30a fit in the sawing line. Given that a sawing line typically is 100µm wide, compensation elements having width in the range 30µm - 180µm can either be positioned wholly within the sawing lines or they can be positioned so that a large fraction of their width is co-located with the sawing lines.

In preferred embodiments of the invention, the length of pattern 30a is dependent on the length of the regions of the IC that have low density of 3D structures (i.e. the length of region B+C in the IC illustrated in Fig.1). For the IC illustrated in Fig.1, an appropriate length for the compensation element 30a is in the range from approximately from 1mm to approximately 1.5 mm.

In preferred embodiments of the invention, the slot(s) forming the compensation element 30a is (are) formed in one or more process steps which also form 3D structures in the IC 10. Accordingly, in such embodiments the depth of the slot 30a is the same as or close to the depth of the 3D structures in the IC 10. For example, the slots of the compensation elements 30a may be etched in a step that also etches wells or pillars for use in forming 3D capacitors in the IC 10, or in a step that etches via-holes in the IC 10.

As noted above, it is preferable for the slots forming the compensation elements 30a not to be left empty, because this could cause issues during lithographic processes performed afterwards during the manufacturing process. Accordingly, in certain embodiments of the invention material is deposited in the compensation elements 30a. In preferred embodiments of the invention, material is deposited into the slot(s) forming the compensation element 30a in one or more process steps which also deposit material to form components of the 3D structures in the IC 10 (e.g. deposited material that forms dielectric and electrode layers in 3D capacitors, deposited material that forms conductive filling in a via, etc.). Accordingly, in such embodiments the materials in the slot 30a are the same as those present in the 3D structures in the ICs 10.

In some cases, it may be preferred to use compensation elements 30a as of the type illustrated in Fg.5 in preference to compensation elements 30 which correspond to a rotated copy of the basic IC. For example, if the IC has a significant aspect ratio (i.e. is significantly rectangular, rather than relatively square) it may be difficult to accommodate the compensation structures 30 among the ICs of the first set 11 without wasting space on the wafer surface. Also, it may be complicated for pick-and-place equipment to adjust to the different orientations of the singulated devices after the wafer has been cut.

A method of manufacturing wafers such as the wafer 20 illustrated in Fig.4 and the wafer 20a illustrated in Fig.5 will be described below.

The manufacturing method comprises forming in a first surface of the wafer a first set 11 of repetitions of the integrated circuit 10 which has structures extending in the thickness-direction of the wafer and these thickness-direction structures are laid out unevenly across the integrated circuit. The positions of the integrated circuits 10 of the first set 11 on the wafer cause a non-uniform distribution of thickness-direction structures over the surface of the wafer. Accordingly, to improve the uniformity of distribution of 3D structures across the overall face of the wafer, the method also comprises forming, in the same surface of the wafer, compensation elements that extend in the thickness direction of the wafer.

Different variants of the manufacturing method may be used to fabricate a wafer 20 as illustrated in Fig.4 or a wafer 20a as illustrated in Fig.5.

In the case of fabricating a wafer 20 as illustrated in Fig.4, one manufacturing method makes use of a special reticle (not shown) which has first and second patterns corresponding to the different IC orientations to be formed on the wafer. More particularly, a set of one or more first patterns on the reticle are designed to form a layer of the integrated circuit 10 in its "normal" orientation (corresponding to the set of repetitions 11 on the wafer) whereas the reticle also has a set of one or more second patterns to form the corresponding IC layer in the rotated orientation required for the compensation pattern 30. This new kind of reticle can be used to expose the wafer, and its position can be shifted using a stepper, according to known techniques.

Another manufacturing method for fabricating a wafer 20 as illustrated in Fig.4, makes use of a standard type of reticle which has a set of one or more patterns on the reticle designed to form a layer of the integrated circuit 10. The surface of the wafer can be exposed using this standard type of reticle in a first operation to define patterning on the wafer for forming ICs of the first set 11. The surface of the wafer can be exposed using this standard type of reticle in a second operation to define patterning on the wafer for forming the compensation elements 30. During the second operation the relative orientation of the wafer and reticle is rotated relative to the orientation that exists during performance of the first operation.

Despite their names, the first and second operations can be performed in any order. Moreover, the translation of the position of the reticle relative to the wafer (e.g. using a stepper) may be performed at different stages in the process. Thus, for example, the first and second operation may be performed in a given region of the wafer before the stepper translates the position of the reticle relative to the wafer. Alternatively, the stepping could be performed to implement one of the first and second operations over a large region of the wafer before changing the relative orientation of the wafer and reticle in rotation and performing the other of the first and second operations over the large region of the wafer.

A manufacturing method for fabricating a wafer 20a as illustrated in Fig.5 may make use of a new reticle (not shown) that includes a pattern to form the compensation element 30a as well as a pattern to form the IC 10. The reticle can then be used to expose the wafer surface using standard exposure and stepper devices.

Figs.6A-6B and 7A-7C illustrate how use of the techniques according to the present invention can reduce warping of a wafer.

FIGs. 6A and 6B are cross-sectional diagrams comparing warping of a wafer 2b in which repetitions of a first example circuit have been manufactured using conventional techniques (first comparative example) and reduced warping that occurs for a wafer 20b manufactured using compensation elements 30 as in Fig.4.

FIGs. 7A and 7B are cross-sectional diagrams comparing warping of a wafer 2c in which repetitions of a second example circuit have been manufactured using conventional techniques (second comparative example) and reduced warping that occurs for a wafer 20c manufactured using compensation elements 30ac which are of the general type illustrated in Fig.5.

Fig.7C is a perspective view of the wafer illustrated in Fig.7B and shows that, in this example, each IC has a region S where there is a high density of 3D structures and a region T where there are few 3D structures (even though other circuit elements, terminals, etc. may be present). In this example, each compensation element 30ac consists of a pair of elongated trenches extending in a direction Q which is substantially perpendicularly to the direction P in which the regions of the IC that have a high density of 3D structures align across the wafer. In this example, the compensation elements 30ac are aligned with the regions T of the ICs in the direction P. It can be seen that the addition of the compensation elements 30ac tends to improve the uniformity of the distribution of 3D structures across the surface 21 of the wafer 20c.

It can be seen from Figs.6A-7C that the techniques according to the invention allow wafer warping to be reduced to a significant degree.

### Additional Variants

Although the present invention has been described above with reference to certain specific embodiments, it will be understood that the invention is not limited by the particularities of the specific embodiments. Numerous variations, modifications and developments may be made in the above-described embodiments within the scope of the appended claims.

## Claims

1. A method of manufacturing integrated circuit devices on a wafer, comprising:
forming in a first surface of the wafer a first set of repetitions of an integrated circuit, said integrated circuit comprising structures extending in the thickness-direction of the wafer and said thickness-direction structures being laid out unevenly across the integrated circuit, wherein the positions of the integrated circuits of the first set on the wafer cause a non-uniform distribution of thickness-direction structures over the surface of the wafer, and
forming, in said first surface of the wafer, compensation elements extending in the thickness direction of the wafer and increasing the uniformity in distribution of thickness-directions structures across the wafer compared to said non-uniform distribution.

2. The manufacturing method according to claim 1, wherein the forming of the compensation elements on the wafer comprises forming, in the first surface of the substrate, a second set of repetitions of said integrated circuit, the integrated circuits of the second set having a rotated orientation on the wafer relative to the orientation of the integrated circuits of the first set.

3. The manufacturing method according to claim 2, wherein the formation of the first and second sets of repetitions of the integrated circuit comprises:
an illumination step in which a layer in the wafer is exposed by light passing through a reticle comprising a set of one or more first patterns corresponding to a layer of said integrated circuit and a set of one or more second patterns corresponding to said layer of the integrated circuit, and the orientations of the second patterns on the reticle are rotated relative to the orientations of the first patterns on the reticle.

4. The manufacturing method according to claim 2, wherein the formation of the first and second sets of repetitions of the integrated circuit comprises:
a first illumination step in which a layer in the wafer is exposed by light passing through a reticle comprising a set of one or more first patterns corresponding to a layer of said integrated circuit, to form repetitions of integrated circuits of said first set.
a rotation step in which the relative orientation of the reticle and wafer is changed by rotation, and
a second illumination step in which said layer in the wafer is exposed by light passing through said reticle, to form repetitions of integrated circuits of said second set.

5. The manufacturing method according to claim 1, wherein the forming of integrated circuits of the first set comprises forming integrated circuits on the wafer at positions causing alignment of thickness-direction structures in rows extending in a first direction across the wafer, and
the forming of the compensation elements on the wafer comprises forming, in the first surface of the substrate, compensation elements extending in a direction transverse to the first direction.

6. The manufacturing method according to claim 1, wherein the forming of the compensation elements extending in a direction transverse to the first direction comprises forming compensation elements located in dicing lanes of the wafer.

7. The manufacturing method according to any one of claims 1 to 6, comprising common process steps to form the thickness-direction structures in the first set of integrated circuits and to form the compensation elements extending in the thickness direction of the wafer.

8. The manufacturing method according to any one of claims 1 to 7, comprising common process steps to deposit material in the thickness-direction structures in the first set of integrated circuits and to deposit said material in the compensation elements extending in the thickness direction of the wafer.

9. A wafer comprising:
in a first surface of the wafer, a first set of repetitions of an integrated circuit, said integrated circuit comprising structures extending in the thickness-direction of the wafer and said thickness-direction structures being laid out unevenly across the integrated circuit, wherein the positions of the integrated circuits of the first set on the wafer cause a non-uniform distribution of thickness-direction structures over the surface of the wafer, and
compensation elements extending in the thickness direction of the wafer and increasing the uniformity in distribution of thickness-directions structures across the wafer compared to said non-uniform distribution.

10. A wafer according to claim 9, wherein the compensation elements comprise a second set of repetitions of said integrated circuit, each disposed on the wafer in an orientation rotated relative to the orientation of the integrated circuits of the first set.

11. A wafer according to claim 9, wherein the integrated circuits of the first set comprise integrated circuits disposed on the wafer at positions causing alignment of thickness-direction structures in rows extending in a first direction across the wafer, and
the compensation elements on the wafer comprise structures extending in a direction transverse to the first direction.

12. A wafer according to claim 11, wherein the compensation elements comprise compensation elements disposed in dicing lanes of the wafer.

13. A wafer according to any one of claims 9-12, wherein one or more materials are present in the thickness-direction structures of the integrated circuits of the first set and the same one or more materials are present in said compensation elements extending in the thickness-direction of the wafer.

14. A reticle to pattern a layer of a wafer in manufacture of an integrated circuit, the integrated circuit comprising structures extending in the thickness-direction of the wafer and said thickness-direction structures being laid out unevenly across the integrated circuit, the reticle comprising:
a set of one or more first patterns corresponding to a layer of the integrated circuit, and
a set of one or more second patterns corresponding to said layer of the integrated circuit, said second pattern being a rotated version of said first pattern to compensate for lack of uniformity in the distribution of thickness-direction structures in said integrated circuit.
